# EUROPEAN PATENT APPLICATION

(11) **EP 4 800 764 A1**
(43) Date of publication of application: **02.09.2026**
(21) Application number: 24882826.1
(22) Date of filing: 23.10.2024
(51) Int. Cl.: H01M 4/38, H01M 10/052, C30B 29/06, H01M 4/02

(54) **ANODE ACTIVE MATERIAL FOR LITHIUM SECONDARY BATTERY AND LITHIUM SECONDARY BATTERY COMPRISING SAME**

(30) Priority: 23.10.2023 KR 20230142466
(71) Applicant: Posco Future M Co., Ltd., Pohang-si, Gyeongsangbuk-do 37918 (KR)
(72) Inventor: LEE, Donggue, Pohang-si, Gyeongsangbuk-do 37918 (KR); LEE, Gaeul, Pohang-si, Gyeongsangbuk-do 37918 (KR); YOON, Hocheol, Pohang-si, Gyeongsangbuk-do 37918 (KR); JUNG, Jikwon, Pohang-si, Gyeongsangbuk-do 37918 (KR)
(74) Representative: Pfenning, Meinig & Partner mbB
(86) International application number: PCT/KR2024/016208
(87) International publication number: WO 2025/089799

(57) **Abstract**

The present invention relates to a negative electrode active material for a lithium secondary battery comprising silicon particles, wherein the silicon particles satisfy Formula 1 below. $0.70 \leq \left[{Dv}_{50}-{Dv}_{10}\right] / \left[{Dv}_{90}-{Dv}_{50}\right] \leq 0.80$

In Formula 1, Dv₅₀ is a particle diameter corresponding to 50% of a cumulative volume in a particle size distribution curve of the silicon particles, Dv₁₀ is a particle diameter corresponding to 10% of the cumulative volume in the particle size distribution curve of the silicon particles, and Dv₉₀ is a particle diameter corresponding to 90% of the cumulative volume in the particle size distribution curve of the silicon particles.

## Description

### [TECHNICAL FIELD]

The present invention relates to a negative electrode active material for a lithium secondary battery and a lithium secondary battery comprising the same.

### [BACKGROUND ART]

Lithium-ion batteries are currently the most widely used secondary battery systems, ranging from portable electronic communication devices and electric vehicles to energy storage systems. Such lithium-ion batteries are coming into the focus of interest because they have advantages such as high energy density, operating voltage, and relatively low self-discharge rate compared to commercial aqueous secondary batteries (Ni-Cd, Ni-MH, etc.). However, considering more efficient usage time in portable devices and improvement of energy characteristics in electric vehicles, improvements in electrochemical characteristics still remain as technical problems to be solved. For this reason, much research and development are currently being conducted across the four major raw materials: positive electrode, negative electrode, electrolyte, and separator.

Among these raw materials, for the negative electrode, graphite-based materials exhibiting excellent capacity retention characteristics and efficiency have been commercialized. However, the relatively low theoretical capacity value (LiC₆: 372 mAh/g) and low discharge capacity ratio of graphite-based materials are somewhat insufficient to meet the high energy and high power density characteristics of batteries required by the market. Therefore, many researchers are interested in group 14 elements (Si, Ge, Sn) on the periodic table, and among them, Si in particular is being spotlighted as a very attractive material due to its very high theoretical capacity (Li₁₅Si₄: 3600 mAh/g) and low operating voltage (~0.1V vs. Li/Li⁺) characteristics.

However, in the case of general silicon-based negative electrode materials, volume changes of up to 300% are involved during cycles, and due to the generation of fine powder and loss of electrical contact caused by particle cracks resulting from continuous charging and discharging, discharge capacity ratios and lifespan characteristics are significantly degraded, making it difficult to apply them to actual batteries.

### [DETAILED DESCRIPTION OF THE INVENTION]

### [TECHNICAL PROBLEM]

Accordingly, an object of the present invention is to provide a silicon-based negative electrode active material with improved capacity and lifespan characteristics, and a lithium secondary battery comprising the same.

### [TECHNICAL SOLUTION]

An embodiment of the present invention provides a negative electrode active material for a lithium secondary battery comprising silicon particles, wherein the silicon particles satisfy Formula 1 below. $0.70 \leq \left[{Dv}_{50}-{Dv}_{10}\right] / \left[{Dv}_{90}-{Dv}_{50}\right] \leq 0.80$

In Formula 1, Dv₅₀ is a particle diameter corresponding to 50% of a cumulative volume in a particle size distribution curve of the silicon particles, Dv₁₀ is a particle diameter corresponding to 10% of the cumulative volume in the particle size distribution curve of the silicon particles, and Dv₉₀ is a particle diameter corresponding to 90% of the cumulative volume in the particle size distribution curve of the silicon particles.

The silicon particles may satisfy Formula 2 below. ${Dv}_{1} \geq 2 μm$

In Formula 2, Dv₁ is a particle diameter corresponding to 1% of a cumulative volume in a particle size distribution curve of the silicon particles.

The silicon particles may satisfy Formula 3 below. ${Dv}_{90} \leq 10 μm$

In Formula 3, Dv₉₀ is a particle diameter corresponding to 90% of a cumulative volume in a particle size distribution curve of the silicon particles.

The silicon particles may satisfy Formula 4 below. $\left[{Dv}_{90}-{Dv}_{10}\right] / {Dv}_{50} \leq 1.1$

In Formula 4, Dv₅₀ is a particle diameter corresponding to 50% of a cumulative volume in a particle size distribution curve of the silicon particles, Dv₁₀ is a particle diameter corresponding to 10% of the cumulative volume in the particle size distribution curve of the silicon particles, and Dv₉₀ is a particle diameter corresponding to 90% of the cumulative volume in the particle size distribution curve of the silicon particles.

A volume average particle diameter (Dv₅₀) of the silicon particles may be 4 to 6 µm.

A circularity of the silicon particles may be 0.86 or more.

A tap density of the silicon particles may be 0.9 g/cm³ or more.

A BET specific surface area of the silicon particles may be 1.4 to 2.2 m²/g.

An average grain size of the silicon particles may be 200 nm or less.

A strain of the silicon particles may be 10×10⁻⁵ or more.

The silicon particles may have a single particle form.

The silicon particles may have a polycrystalline structure.

An Si purity of the silicon particles may be 98% or more.

Another embodiment of the present invention provides a negative electrode for a lithium secondary battery comprising the aforementioned negative electrode active material.

Another embodiment of the present invention provides a lithium secondary battery comprising the negative electrode for a lithium secondary battery.

### [ADVANTAGEOUS EFFECTS]

According to an embodiment of the present invention, as the negative electrode active material for a lithium secondary battery satisfies Formula 1 or the like, capacity and lifespan characteristics can be improved.

### [BRIEF DESCRIPTION OF DRAWINGS]

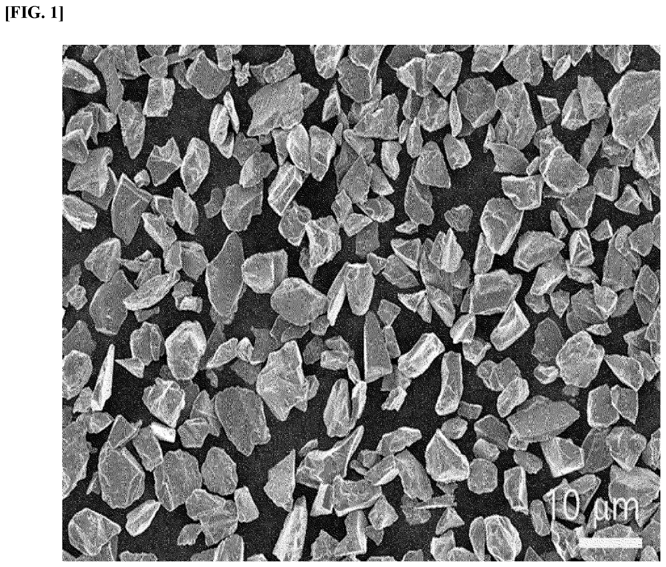

FIG. 1 is an SEM image of a negative electrode active material manufactured according to Example 1.

### [DETAILED DESCRIPTION OF THE EMBODIMENTS]

Terms such as first, second, and third are used to describe various parts, components, regions, layers, and/or sections, but are not limited thereto. These terms are used only to distinguish one part, component, region, layer, or section from another part, component, region, layer, or section. Accordingly, a first part, component, region, layer, or section described below may be referred to as a second part, component, region, layer, or section without departing from the scope of the present invention.

The terminology used herein is for the purpose of referring to specific embodiments only and is not intended to limit the present invention. As used herein, the singular forms include the plural forms as well, unless the phrases clearly indicate the opposite. The meaning of "comprising" as used in the specification specifies a specific characteristic, region, integer, step, operation, element, and/or component, and does not exclude the presence or addition of other characteristics, regions, integers, steps, operations, elements, and/or components.

When a part is referred to as being "on" or "above" another part, it may be directly on or above the other part, or another part may be involved therebetween. In contrast, when a part is referred to as being "directly on" another part, no other part is interposed therebetween.

Unless otherwise defined, all terms including technical and scientific terms used herein have the same meaning as commonly understood by one of ordinary skill in the art to which the present invention belongs. Terms defined in commonly used dictionaries are further interpreted to have meanings consistent with relevant technical literature and the currently disclosed content, and are not interpreted in an ideal or very formal sense unless defined.

In addition, unless otherwise specified, % means weight %, and 1 ppm is 0.0001 weight %.

In the present specification, the term "combination(s) thereof" described in the Markush-type expression refers to a mixture or combination of one or more selected from the group consisting of the components described in the Markush-type expression, and means including one or more selected from the group consisting of the components.

Hereinafter, embodiments of the present invention will be described in detail so that those of ordinary skill in the art to which the present invention belongs can easily practice the invention. However, the present invention may be implemented in many different forms and is not limited to the embodiments described herein.

### 1. Negative Electrode Active Material

A negative electrode active material for a lithium secondary battery according to an embodiment of the present invention comprises silicon particles. As the negative electrode active material for a lithium secondary battery according to the present invention comprises silicon particles, significantly higher capacity characteristics can be implemented compared to carbon-based negative electrode active materials commonly used in the prior art.

Specifically, the Si purity of the silicon particles may be 98% or more, and more specifically, 99% or 99.5% or more.

In addition, the silicon particles may have a single particle form. That is, the silicon particles may have a single particle form consisting of one primary particle, rather than a secondary particle formed by the agglomeration of a plurality of primary particles. As the silicon particles are single particles, there may be an advantage of uniform particle size distribution. Meanwhile, "primary particle" refers to the minimum particle unit distinguished as one lump when observing a cross-section of the negative electrode active material through a scanning electron microscope (SEM), and may consist of one crystalline grain or a plurality of crystalline grains. In addition, "crystalline grain" refers to a distinct region in which atoms within the primary particle form a lattice structure in a certain direction.

In addition, the silicon particles may have a polycrystalline structure. As the silicon particles are polycrystalline, there may be an advantage in that cycle life is improved.

However, in the case of general silicon negative electrode materials, volume changes of up to 300% are involved during cycles, and due to the generation of fine powder and loss of electrical contact caused by particle cracks resulting from continuous charging and discharging, discharge capacity ratios and lifespan characteristics are significantly degraded, making it difficult to apply them to actual batteries.

Accordingly, the silicon particles according to the present invention satisfy Formula 1 below. $0.70 \leq \left[{Dv}_{50}-{Dv}_{10}\right] / \left[{Dv}_{90}-{Dv}_{50}\right] \leq 0.80$

In Formula 1, Dv₅₀ is a particle diameter corresponding to 50% of a cumulative volume in a particle size distribution curve of the silicon particles, Dv₁₀ is a particle diameter corresponding to 10% of the cumulative volume in the particle size distribution curve of the silicon particles, and Dv₉₀ is a particle diameter corresponding to 90% of the cumulative volume in the particle size distribution curve of the silicon particles. The Dv₅₀, Dv₉₀, and Dv₁₀ can be measured, for example, using a laser diffraction method. The laser diffraction method generally enables measurement of particle diameters from a submicron region to about several mm, and results with high reproducibility and high resolution can be obtained. As a laser diffraction analysis device, SALD-2300 equipment from Shimadzu Corporation may be used, and ethanol may be used as a solvent for particle size analysis.

As the silicon particles satisfy Formula 1, the capacity, initial efficiency, and lifespan characteristics of the battery can be excellently improved.

More specifically, the value of [Dv₅₀ - Dv₁₀] / [Dv₉₀ - Dv₅₀] can represent the ratio of fine powder to coarse powder among a plurality of silicon particle powders. A smaller value of [Dv₅₀ - Dv₁₀] / [Dv₉₀ - Dv₅₀] means that the ratio of fine powder to coarse powder is small, and a larger value of [Dv₅₀ - Dv₁₀] / [Dv₉₀ - Dv₅₀] may mean that the ratio of fine powder to coarse powder is large. At this time, if the value of [Dv₅₀ - Dv₁₀] / [Dv₉₀ - Dv₅₀] is too large, it means that the ratio of fine powder is too high, and problems such as gas generation due to side reactions with the electrolyte and loss of electrical contact may occur, thereby degrading lifespan characteristics. If the value of [Dv₅₀ - Dv₁₀] / [Dv₉₀ - Dv₅₀] is too small, it means that the ratio of coarse powder is too high, and the volume expansion rate increases, which may rather degrade lifespan characteristics.

In addition, the present inventors have confirmed through experiments that as the silicon particles according to the present invention satisfy Formula 1, not only lifespan characteristics but also capacity and initial efficiency are improved. This seems to be because the silicon particles uniformly participate in the electrochemical reaction due to the optimal ratio of fine powder and coarse powder.

In addition, the silicon particles may satisfy Formula 2 below. ${Dv}_{1} \geq 2 μm$

In Formula 2, Dv₁ is a particle diameter corresponding to 1% of a cumulative volume in a particle size distribution curve of the silicon particles.

As the silicon particles satisfy Formula 2, the ratio of fine powder with a too small particle diameter decreases, so that lifespan characteristics and tap density can be improved.

Specifically, the Dv₁ value may be 2.2 µm or 2.4 µm or more.

The silicon particles may satisfy Formula 3 below. ${Dv}_{90} \leq 10 μm$

In Formula 3, Dv₉₀ is a particle diameter corresponding to 90% of a cumulative volume in a particle size distribution curve of the silicon particles.

As the silicon particles satisfy Formula 3, the ratio of coarse particles with a too large particle diameter can decrease. A large amount of coarse particles may generate a large amount of fine powder due to crack generation according to continuous contraction and expansion as charging and discharging are repeated, and the movement length of lithium ions in the silicon particles becomes long, which may cause degradation of capacity or initial efficiency. Therefore, as the ratio of coarse particles is reduced, the fine powder generation rate according to repeated charging and discharging is reduced, so that lifespan characteristics can be improved. In addition, by reducing the movement length of lithium ions in the silicon particles, capacity and initial efficiency can be improved.

More specifically, the Dv₉₀ may be 9 µm, 8 µm, or 7.7 µm or less.

The silicon particles may satisfy Formula 4 below. $\left[{Dv}_{90}-{Dv}_{10}\right] / {Dv}_{50} \leq 1.1$

In Formula 4, Dv₅₀ is a particle diameter corresponding to 50% of a cumulative volume in a particle size distribution curve of the silicon particles, Dv₁₀ is a particle diameter corresponding to 10% of the cumulative volume in the particle size distribution curve of the silicon particles, and Dv₉₀ is a particle diameter corresponding to 90% of the cumulative volume in the particle size distribution curve of the silicon particles.

If the [Dv₉₀ - Dv₁₀] / Dv₅₀ value of the silicon particles is too large, it means that the particle size distribution of the particles becomes too wide, and there may be a problem of degradation of lifespan characteristics due to a large amount of coarse powder and fine powder.

More specifically, the [Dv₉₀ - Dv₁₀] / Dv₅₀ value may be 1, 0.95, 0.9, or 0.87 or less.

The volume average particle diameter (Dv₅₀) of the silicon particles may be 4 to 6 µm. If the volume average particle diameter of the silicon particles is too small, the specific surface area becomes large, so there may be problems of decreased efficiency and degraded lifespan characteristics. If the volume average particle diameter of the silicon particles is too large, pulverization is accelerated, and there may be a problem of degraded lifespan characteristics.

The circularity of the silicon particles may be 0.86 or more. As the circularity of the silicon particles is sufficiently large, the tap density increases to improve the energy density of the electrode, and the volume expansion of the active material during charging decreases, so that the lifespan characteristics of the battery can be improved. However, in terms of process efficiency and cost, and considering the effect of improving battery performance, increasing the circularity more than necessary may be uneconomical. The circularity of silicon particles is a numerical expression of the degree to which a particle is close to a circle, and refers to a value obtained by dividing the circumference of a particle shape by the circumference of a circle having an equivalent area in an individual 2D image for each particle through an image analysis device. Such circularity can be measured using an analyzer for obtaining optical images (Malvern Panalytical, Morphologi 4).

The tap density of the silicon particles may be 0.9 g/cm³ or more, and more specifically, 1.0 g/cm³ or 1.04 g/cm³ or more. As the tap density of the silicon particles is sufficiently large, the energy density of the electrode can be improved. The tap density of silicon particles can be measured by a method generally used in the art as a method for measuring the degree of filling of a sample per unit volume. For example, it may be a density (sample weight/volume) calculated through a change in volume after mechanically tapping a measurement container containing a sample from a certain height for a fixed number of times in accordance with the measurement device and method prescribed in ASTM B527.

The BET specific surface area of the silicon particles may be 1.4 to 2.2 m²/g. If the specific surface area of the silicon particles is too small, it means that there is too much coarse powder, so capacity, initial efficiency, and lifespan characteristics may be degraded. If the specific surface area of the silicon particles is too large, it means that there is too much fine powder, and capacity, initial efficiency, and lifespan characteristics may be degraded due to the same reasons described in Formula 1 above.

The average grain size of the silicon particles may be 200 nm or less, more specifically 180 nm or 160 nm or less, and 140 nm or 145 nm or more. As the average grain size of the silicon particles is sufficiently small in this way, the degree of volume expansion and contraction during charging and discharging decreases, so that the lifespan characteristics of the battery can be improved. However, if the grain size of the silicon particles is too small, particles may be broken by excessive processing, or the aspect of charging and discharging volume change may vary.

In the present specification, the grain size of the silicon particles can be measured by analyzing X-ray diffraction data of a cross-section of the active material by the Rietveld refinement method. For example, the grain size can be obtained by performing X-ray diffraction analysis using Bruker's D8 Discover with GADDS XRD equipment under the following conditions to obtain XRD data, and then processing the XRD data using Bruker's DIFFRAC.TOPAS program. At this time, the full width at half maximum (FWHM) was set to be measured using the Caglioti equation.

### <X-ray Diffraction Analysis Conditions>

Light source: Cu-target, 45 kV, 40 mA output, wavelength = 1.54 Å
Detector: GaliPIX3D
Sample preparation: A sample of about 2 g was filled in a 2 cm diameter holder and loaded onto a rotation stage.
Measurement time: about 20 minutes
Measurement area: 2θ = 10° to 90°

The strain of the silicon particles may be 10×10⁻⁵ or more, and more specifically, 10.5×10⁻⁵ or 11.7×10⁻⁵ or more, and 13×10⁻⁵ or less or 12.5×10⁻⁵ or less. As the strain of the silicon particles is sufficiently large as described above, the lifespan characteristics of the battery can be improved. However, if the strain of the silicon particles is too large, the internal stress of the particles increases, making them vulnerable to impact, and pulverization of the particles may proceed rapidly due to volume expansion during charging, so that electrode degradation may occur quickly.

In the present specification, strain is a value measured through Rietveld refinement analysis of X-ray diffraction data, representing the average deviation of the lattice spacing d and the degree of deformation of the crystal lattice, and satisfies the following equation. ${ε}_{0} = \frac{Δ d}{d} = \frac{{β}_{FWHM \left(str\right)}}{4 tan θ}$

In this case, *β_{FWHM(str)}* represents the full width at half maximum of the profile component related to micro-strain expansion.

### 2. Method for Manufacturing Negative Electrode Active Material

Various physical properties of the silicon particles according to the present invention, including the aforementioned [Dv₅₀ - Dv₁₀] / [Dv₉₀ - Dv₅₀] value, can be appropriately obtained within the ranges according to the present invention when manufactured according to the following series of manufacturing methods.

Hereinafter, a method for manufacturing a negative electrode active material for a lithium secondary battery according to another embodiment of the present invention will be described.

A method for manufacturing a negative electrode active material for a lithium secondary battery according to another embodiment of the present invention may include: a first grinding of metallurgical silicon powder; a second grinding of the first-ground metallurgical silicon powder; a first classification of the second-ground metallurgical silicon powder; a third grinding of the first-classified metallurgical silicon powder; and a second classification of the third-ground metallurgical silicon powder. Hereinafter, each step will be described in more detail.

First, metallurgical silicon powder is subjected to a first grinding.

In this case, the metallurgical silicon powder may contain 98% or more of silicon and other unavoidable impurities based on the total weight.

The first grinding may be performed using equipment commonly used in the art and is not particularly limited. For example, the first grinding may be performed using a rotary cutter mill, but is not limited thereto.

In this case, the first grinding may be performed such that the volume-based particle diameter (D₉₀) of the metallurgical silicon powder is 4 mm or less. Accordingly, grinding efficiency in a subsequent second grinding process can be increased, and coarse powder having a too large particle diameter can be primarily removed.

Next, the first-ground metallurgical silicon powder is subjected to a second grinding.

The second grinding may be performed using equipment commonly used in the art and is not particularly limited. For example, the second grinding may be performed using one or more selected from a jet mill, a ball mill, a stirred media mill, a roll mill, a hammer mill, a pin mill, a disk mill, a colloid mill, and an atomizer mill, but is not limited thereto.

In this case, the second grinding may be performed such that the volume-based particle diameter (Dv₃₀) of the metallurgical silicon powder is 150 µm or more. Accordingly, generation of a large amount of fine powder to ultrafine powder in a subsequent third grinding process can be prevented. More specifically, by removing metallurgical silicon powder having a too small volume-based particle diameter (Dv₃₀) during the second grinding, collisions between particles of an appropriate particle diameter can be induced in the subsequent third grinding process, thereby preventing the generation of a large amount of fine powder to ultrafine powder in the final product.

Next, the second-ground metallurgical silicon powder is subjected to a first classification.

The first classification may be performed, for example, through mesh classification, but is not necessarily limited thereto.

In this case, the first classification may be performed to remove metallurgical silicon powder having a particle diameter of less than 100 µm. Accordingly, grinding efficiency in the subsequent third grinding process can be improved, and the fine powder generation rate in the final product can be reduced. The upper limit of the particle diameter of the metallurgical silicon powder to be removed can be performed, for example, by appropriately adjusting the diameter of a mesh screen perforation.

Next, the first-classified metallurgical silicon powder is subjected to a third grinding.

The third grinding may be performed using grinding equipment commonly used in the art and is not particularly limited. For example, the third grinding may be performed using one or more selected from a jet mill, a spiral jet mill, a ball mill, a stirred media mill, a roll mill, a hammer mill, a pin mill, a disk mill, a colloid mill, and an atomizer mill, but is not limited thereto.

In this case, the third grinding may be performed such that the average particle diameter (D₅₀) of the metallurgical silicon powder is 4 to 6 µm. Accordingly, the average particle diameter (D₅₀) of the final product can be appropriately obtained within the range according to the present invention.

Next, the third-ground metallurgical silicon powder is subjected to a second classification.

The second classification may use any one of, for example, a gravitational type, an inertial type, and a centrifugal type, but is not necessarily limited thereto.

In this case, the second classification may be controlled such that the yield of metallurgical silicon powder (the final product) satisfying a SPAN ((D₉₀-D₁₀)/D₅₀) value of 1 or less as a result of the second classification is 30 to 40% based on the total weight of the metallurgical silicon powder, which is the starting raw material, and more specifically, 32 to 48%.

In the present specification, the SPAN value refers to a value derived by calculating [particle diameter (D₉₀) - particle diameter (D₁₀)] / particle diameter (D₅₀). In this case, the particle diameter (D₉₀), particle diameter (D₁₀), and particle diameter (D₅₀) can be defined as particle diameters corresponding to 90%, 10%, and 50% of the cumulative volume in the particle size distribution curve of the particles, respectively.

More specifically, the second classification may include: removing fine powder of the third-ground metallurgical silicon powder; and removing coarse powder of the third-ground metallurgical silicon powder. In the step of removing the fine powder, fine powder having a particle diameter of 0.5 µm or less may be removed, and in the step of removing the coarse powder, coarse powder having a particle diameter of 25 µm or more may be removed.

Through the series of processes described above, a negative electrode active material for a lithium secondary battery according to the present invention can be manufactured, and various physical properties such as [Dv₅₀ - Dv₁₀] / [Dv₉₀ - Dv₅₀] of the manufactured negative electrode active material can be appropriately obtained within the range according to the present invention. Accordingly, the capacity, initial efficiency, and lifespan characteristics of the battery can be uniformly improved.

### 3. Negative Electrode and Lithium Secondary Battery

Another embodiment of the present invention provides a negative electrode comprising the aforementioned negative electrode active material and a lithium secondary battery comprising the same.

A negative electrode for a lithium secondary battery according to another embodiment of the present invention may more specifically include: a negative electrode current collector; and a negative electrode active material layer located on the negative electrode current collector and comprising the aforementioned negative electrode active material for a lithium secondary battery.

The negative electrode current collector is not particularly limited as long as it has high conductivity without causing chemical change in the battery, and for example, copper, stainless steel, aluminum, nickel, titanium, sintered carbon, copper or stainless steel surface-treated with carbon, nickel, titanium, silver, or the like, an aluminum-cadmium alloy, or the like may be used. In addition, the negative electrode current collector may typically have a thickness of 3 to 500 µm, and similar to a positive electrode current collector, fine irregularities may be formed on the surface of the current collector to strengthen the binding force of the negative electrode active material. For example, it may be used in various forms such as a film, a sheet, a foil, a net, a porous body, a foam, and a non-woven fabric.

The negative electrode active material layer may optionally include a binder and/or a conductive material along with the negative electrode active material.

The binder serves to improve the adhesion between negative electrode active material particles and the adhesion between the negative electrode active material and the negative electrode current collector. Specific examples include polyvinylidene fluoride (PVDF), vinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, polytetrafluoroethylene, polyethylene, polypropylene, ethylene-propylene-diene monomer rubber (EPDM rubber), sulfonated EPDM, styrene-butadiene rubber (SBR), fluororubber, or various copolymers thereof, and one type alone or a mixture of two or more types thereof may be used. The binder may be included in an amount of 1 to 30% by weight based on the total weight of the negative electrode active material layer.

The conductive material is used to impart conductivity to the electrode, and can be used without particular limitation as long as it has electronic conductivity without causing chemical change in the battery configured. Specific examples include: graphite such as natural graphite or artificial graphite; carbon-based materials such as carbon black, acetylene black, ketjen black, channel black, furnace black, lamp black, thermal black, and carbon fiber; metal powders or metal fibers such as copper, nickel, aluminum, and silver; conductive whiskers such as zinc oxide and potassium titanate; conductive metal oxides such as titanium oxide; or conductive polymers such as polyphenylene derivatives, and one type alone or a mixture of two or more types thereof may be used. The conductive material may typically be included in an amount of 1 to 30% by weight based on the total weight of the negative electrode active material layer.

The negative electrode for a lithium secondary battery according to an embodiment of the present invention may be manufactured according to a conventional negative electrode manufacturing method, except for using the aforementioned negative electrode active material.

Specifically, it may be manufactured by applying a composition for forming a negative electrode active material layer, which comprises the aforementioned negative electrode active material and optionally a binder, a conductive material, and a solvent, onto a negative electrode current collector, followed by rolling and drying. In this case, the types and contents of the negative electrode active material, the binder, and the conductive material are as described above.

The solvent may be a solvent commonly used in the art, and examples thereof include dimethylsulfoxide (DMSO), isopropyl alcohol, N-methylpyrrolidone (NMP), acetone, or water, and one type alone or a mixture of two or more types thereof may be used. The amount of the solvent used is sufficient as long as it dissolves or disperses the negative electrode active material, the conductive material, and the binder in consideration of the coating thickness of the slurry and the manufacturing yield, and has a viscosity that can exhibit excellent thickness uniformity during subsequent coating for manufacturing the negative electrode.

As another method, the negative electrode may be manufactured by casting the composition for forming a negative electrode active material layer onto a separate support and then laminating a film obtained by peeling from the support onto a negative electrode current collector.

Another embodiment of the present invention provides a lithium secondary battery comprising the aforementioned negative electrode for a lithium secondary battery.

The lithium secondary battery may more specifically include a positive electrode, a negative electrode located opposite the positive electrode, a separator interposed between the positive electrode and the negative electrode, and an electrolyte.

The positive electrode, the separator, and the electrolyte other than the negative electrode can be used without limitation as long as they are generally used in the art.

Hereinafter, embodiments of the present invention will be described in more detail through examples. However, the following examples are only preferred examples of the present invention, and the present invention is not limited by the following examples.

### Example 1

### (1) Manufacture of Negative Electrode Active Material

(First Grinding) Metallurgical silicon powder having a purity of 98% was subjected to a first grinding using rotary cutter mill equipment. At this time, process conditions were adjusted to form metallurgical silicon powder having a volume-based particle diameter (Dv₉₀) of 4 mm or less.

(Second Grinding) Thereafter, the metallurgical silicon powder was subjected to a second grinding using disk mill equipment. At this time, a disk interval was adjusted to form metallurgical silicon powder having a volume-based particle diameter (Dv₃₀) of 200 µm or more.

(First Classification) Thereafter, the metallurgical silicon powder was subjected to a first classification by a mesh classification method. At this time, 200 mesh was used to remove metallurgical silicon powder having a particle diameter of less than 100 µm.

(Third Grinding) Thereafter, the metallurgical silicon powder was subjected to a third grinding using jet mill equipment. At this time, jet pressure (6 bar or more) and raw material input rate were adjusted so that a volume-based average particle diameter (Dv₅₀) was 4 to 6 µm. In this case, the optimal conditions for the jet pressure and the input rate may vary depending on the specifications of the jet mill.

(Second Classification) Thereafter, the metallurgical silicon powder was subjected to a second classification by an air current classification method. At this time, coarse powder having a particle diameter of 25 µm or more and fine powder having a particle diameter of 0.5 µm or less were removed through air current classification. Through this, the yield of silicon particles (final product) satisfying a SPAN ((D₉₀-D₁₀)/D₅₀) value of 1 or less was controlled to be 35% based on the total weight of the metallurgical silicon powder, which is the starting raw material.

### (2) Manufacture of Negative Electrode

The manufactured negative electrode active material, a conductive material, styrene butadiene rubber (SBR) as a binder, and carboxymethyl cellulose (CMC) as a thickener were mixed in a mass ratio of 96:1:1.5:1.5, and then dispersed in deionized water to prepare a negative electrode active material layer composition. After applying the composition to a Cu-foil current collector, it was dried and rolled to manufacture a negative electrode having an electrode density of 1.40±0.05 g/cm³.

### (3) Manufacture of Lithium Secondary Battery

Using the negative electrode as a working electrode and metallic lithium as a counter electrode, a coin-type 2032 half-cell was manufactured. At this time, a separator made of a porous polypropylene film was inserted between the working electrode and the counter electrode, and as an electrolyte, a 1M concentration of LiPF₆ dissolved in a mixed solution in which the mixed volume ratio of fluoroethylene carbonate (FEC) and ethyl methyl carbonate (EMC) was 3:7 was used.

### Example 2

A negative electrode active material, a negative electrode, and a lithium secondary battery were manufactured in the same manner as in Example 1, except that 270 mesh was used in the first classification step to remove metallurgical silicon powder having a particle diameter of less than 70 µm.

### Example 3

A negative electrode active material, a negative electrode, and a lithium secondary battery were manufactured in the same manner as in Example 1, except that 325 mesh was used in the first classification step to remove metallurgical silicon powder having a particle diameter of less than 50 µm.

### Example 4

A negative electrode active material, a negative electrode, and a lithium secondary battery were manufactured in the same manner as in Example 1, except that the disk interval was adjusted in the second grinding step to form metallurgical silicon powder having a volume-based particle diameter (Dv₃₀) of 150 µm or more.

### Comparative Example 1

A negative electrode active material, a negative electrode, and a lithium secondary battery were manufactured in the same manner as in Example 1, except that the first classification step was not performed.

### Comparative Example 2

A negative electrode active material, a negative electrode, and a lithium secondary battery were manufactured in the same manner as in Example 1, except that in the second classification step, the speed of the fine powder adjustment classification wheel was accelerated to partially increase the content of fine powder, and the yield of a SPAN value of 1 or less was set to a level of 41%.

### Comparative Example 3

A negative electrode active material, a negative electrode, and a lithium secondary battery were manufactured in the same manner as in Example 1, except that in the second grinding step, the grinding intensity was strongly adjusted to form metallurgical silicon powder having a volume-based particle diameter (Dv₃₀) of 100 µm or less, and the first classification step was not performed.

### Comparative Example 4

A negative electrode active material, a negative electrode, and a lithium secondary battery were manufactured in the same manner as in Example 1, except that the second classification step was not performed.

Table 1 below is a table summarizing process conditions of Examples and Comparative Examples.

**[Table 1]**

| | First grinding | Second grinding | First classification | Third grinding | Second classification (=Product) |
|---|---|---|---|---|---|
| Ex.1 | Dv90 ≤ 4mm | 200um ≤ Dv30 | Removal of particles less than 100 µm (200 mesh) | Dv50 4~6um | Yield of 35% with SPAN of 1 or less |
| Ex.2 | Dv90 ≤ 4mm | 200um ≤ Dv30 | Removal of particles less than 70 µm (270 mesh) | Dv50 4~6um | Same as Example 1 |
| Ex.3 | Dv90 ≤ 4mm | 200um ≤ Dv30 | Removal of particles less than 50 µm (325 mesh) | Dv50 4~6um | Same as Example 1 |
| Ex.4 | Dv90 ≤ 4mm | 150um ≤ Dv30 | Removal of particles less than 100 µm (200 mesh) | Dv50 4~6um | Same as Example 1 |
| C-Ex.1 | Dv90 ≤ 4mm | 200um ≤ Dv30 | X | Dv50 4~6um | Same as Example 1 |
| C-Ex.2 | Dv90 ≤ 4mm | 200um ≤ Dv30 | Removal of particles less than 100 µm (200 mesh) | Dv50 4~6um | Yield of 41% with SPAN of 1 or less |
| C-Ex.3 | Dv90 ≤ 4mm | Dv30 ≤ 100um | X | Dv50 4~6um | Same as Example 1 |
| C-Ex.4 | Dv90 ≤ 4mm | 200um ≤ Dv30 | Removal of particles less than 100 µm (200 mesh) | Dv50 4~6um | X |

### Experimental Example 1: Evaluation of SEM Images of Negative Electrode Active Material

SEM images of the negative electrode active material prepared according to Example 1 were evaluated, and the results are shown in FIG. 1.

Referring to FIG. 1, it was confirmed that the negative electrode active material of Example 1 has a single particle form.

### Experimental Example 2: Evaluation of Physical Properties of Negative Electrode Active Material

### (1) Evaluation of volume-based particle diameters (Dv₁, Dv₁₀, Dv₅₀, Dv₉₀)

Volume-based particle diameters (Dv₁, Dv₁₀, Dv₅₀, Dv₉₀) were evaluated using a laser diffraction method. Dv₁, Dv₁₀, Dv₅₀, and Dv₉₀ may be defined as the particle diameters corresponding to 1%, 10%, 50%, and 90% of the cumulative volume, respectively, in a particle size distribution curve of the particles. In this case, a SALD-2300 device from Shimadzu Corporation was used as the laser diffraction analysis equipment, and ethanol was used as the solvent for the particle size analysis.

### (2) Evaluation of tap density

Based on ASTM-B527, 15 g of the active material powder was placed in a 25 mL cylinder, and then tapped for 3,000 cycles at 284 cycles/min to measure the packing density.

### (3) Evaluation of BET specific surface area

The specific surface area was measured using the BET method (Surface area and Porosity analyzer; Micromeritics, ASAP2020).

### (4) Evaluation of average crystal size

XRD data of the active material were measured using a D8 Discover with GADDS XRD device from Bruker, and the average crystal size was evaluated through the Rietveld refinement method embedded in the DIFFRAC.TOPAS program from Bruker.

**[Table 2]**

| | Dv1 (um) | Dv10 (um) | Dv50 (um) | Dv90 (um) | SPAN | [Dv50-Dv10]/ [Dv90-Dv50] |
|---|---|---|---|---|---|---|
| Ex.1 | 2.55 | 3.37 | 5.15 | 7.57 | 0.82 | 0.73 |
| Ex.2 | 2.42 | 3.15 | 4.96 | 7.41 | 0.86 | 0.74 |
| Ex.3 | 2.23 | 3.00 | 4.82 | 7.31 | 0.89 | 0.73 |
| Ex.4 | 2.22 | 2.87 | 4.80 | 7.30 | 0.92 | 0.77 |
| C-Ex.1 | 2.28 | 3.14 | 5.06 | 7.49 | 0.86 | 0.82 |
| C-Ex.2 | 1.99 | 2.78 | 4.99 | 7.21 | 0.89 | 0.94 |
| C-Ex.3 | 1.78 | 2.69 | 4.86 | 7.32 | 0.95 | 0.82 |
| C-Ex.4 | 0.70 | 1.75 | 4.28 | 7.17 | 1.27 | 0.88 |

**[Table 3]**

| | Tap density (g/cc) | BET specific surface area (m²/g) | Average crystal size (nm) |
|---|---|---|---|
| Ex.1 | 1.09 | 1.40 | 160 |
| Ex.2 | 1.06 | 1.63 | 159 |
| Ex.3 | 0.96 | 1.90 | 174 |
| Ex.4 | 0.99 | 2.20 | 157 |
| C-Ex.1 | 1.00 | 2.21 | 174 |
| C-Ex.2 | 0.96 | 2.09 | 182 |
| C-Ex.3 | 0.99 | 3.01 | 171 |
| C-Ex.4 | 0.97 | 1.99 | 183 |

Referring to Tables 2 and 3, in the case of the negative electrode active materials of the Examples in which the process conditions according to the present invention were appropriately controlled, it was confirmed that overall physical properties including the value of [Dv₅₀ - Dv₁₀] / [Dv₉₀ - Dv₅₀] were appropriately obtained within the ranges according to the present invention.

On the other hand, in the case of Comparative Example 1, as a result of not performing the first classification, it was confirmed that the value of [Dv₅₀ - Dv₁₀] / [Dv₉₀ - Dv₅₀] was out of the range according to the present invention.

In the case of Comparative Example 2, as a result of excessive acceleration of the fine powder control classification wheel speed during the second classification, it was confirmed that the value of [Dv₅₀ - Dv₁₀] / [Dv₉₀ - Dv₅₀] and the Dv₁ value were out of the ranges according to the present invention.

In the case of Comparative Example 3, as a result of adjusting Dv₃₀ to be too small during the second pulverization and not performing the first classification, it was confirmed that the value of [Dv₅₀ - Dv₁₀] / [Dv₉₀ - Dv₅₀] and the Dv₁ value were out of the ranges according to the present invention.

In the case of Comparative Example 4, as a result of not performing the second classification, it was confirmed that the value of [Dv₅₀ - Dv₁₀] / [Dv₉₀ - Dv₅₀], the Dv₁ value, and the SPAN value were out of the ranges according to the present invention.

### Experimental Example 3: Evaluation of Electrochemical Characteristics of Lithium Secondary Battery

### (1) Evaluation of initial discharge capacity and initial efficiency

After fabricating a lithium secondary battery CR2032 half-cell, it was aged at 25°C for 30 hours, and then a charge/discharge test was performed. For initial capacity evaluation, 3,500 mAh/g was set as a reference capacity, and the cell was charged to 5 mV at a constant current of 0.1 C, and then switched to a constant voltage until the ending current reached 0.005 C. After a rest time of 10 minutes following charging, discharge was performed until reaching 1.0 V at a constant current of 0.1 C with 3,500 mAh/g as a reference capacity.

### (2) Evaluation of lifespan characteristics

For lifespan characteristics, the cell was charged to 5 mV at a constant current of 0.5 C at 25°C and then switched to a constant voltage until the ending current reached 0.005 C. After a rest time of 10 minutes following charging, discharge was performed at a constant current of 0.5 C until reaching 1.0 V. Under these charge/discharge conditions, 100 cycles of charging and discharging were performed, and the capacity retention rate of the 100th cycle relative to the first cycle was calculated.

**[Table 4]**

| | Initial Capacity | Initial Efficiency | 100^{th} cycle |
|---|---|---|---|
| | (mAh/g) | (%) | retention (%) |
| Ex.1 | 3626 | 93.1 | 94.6 |
| Ex.2 | 3658 | 93 | 94.7 |
| Ex.3 | 3558 | 93.6 | 94.3 |
| Ex.4 | 3590 | 92.9 | 94.1 |
| C-Ex.1 | 3528 | 91.8 | 93.9 |
| C-Ex.2 | 3493 | 91.2 | 92.4 |
| C-Ex.3 | 3465 | 91 | 91 |
| C-Ex.4 | 3530 | 90.3 | 90.1 |

Referring to Table 4, in the case of the Examples in which overall physical properties including the value of [Dv₅₀ - Dv₁₀] / [Dv₉₀ - Dv₅₀] of the negative electrode active material satisfy the ranges according to the present invention, it was confirmed that initial capacity, initial efficiency, and lifespan characteristics were all significantly excellent. Conversely, in the case of the Comparative Examples in which the value of [Dv₅₀ - Dv₁₀] / [Dv₉₀ - Dv₅₀] deviated from the range according to the present invention, and additionally, the Dv₁ value or SPAN value deviated from the ranges according to the present invention, it was confirmed that initial capacity, initial efficiency, and lifespan characteristics were deteriorated compared to those of the Examples.

Meanwhile, comparing Examples 1 to 2 with Examples 3 to 4, it was confirmed that in the case of Examples 1 to 2 in which the Dv₁ value was more controlled in addition to the value of [Dv₅₀ - Dv₁₀] / [Dv₉₀ - Dv₅₀], capacity, lifespan characteristics, and tap density (refer to Table 3 for this) were more preferably implemented compared to those of Examples 3 to 4.

While the preferred embodiments of the present invention have been described above, the present invention is not limited thereto, and it will be understood that various modifications may be made within the scope of the claims, the detailed description of the invention, and the accompanying drawings, and such modifications are intended to fall within the scope of the present invention. Accordingly, the substantial scope of the present invention is defined by the appended claims and their equivalents.

## Claims

1. A negative electrode active material for a lithium secondary battery, comprising:
silicon particles,
wherein the silicon particles satisfy Formula 1 below: $0.70 \leq \left[{Dv}_{50}-{Dv}_{10}\right] / \left[{Dv}_{90}-{Dv}_{50}\right] \leq 0.80$
wherein, in Formula 1, Dv₅₀ is a particle diameter corresponding to 50% of a cumulative volume in a particle size distribution curve of the silicon particles, Dv₁₀ is a particle diameter corresponding to 10% of the cumulative volume in the particle size distribution curve of the silicon particles, and Dv₉₀ is a particle diameter corresponding to 90% of the cumulative volume in the particle size distribution curve of the silicon particles.

2. The negative electrode active material for a lithium secondary battery of claim 1,
wherein the silicon particles satisfy Formula 2 below: ${Dv}_{1} \geq 2 μm$
wherein, in Formula 2, Dv₁ is a particle diameter corresponding to 1% of a cumulative volume in a particle size distribution curve of the silicon particles.

3. The negative electrode active material for a lithium secondary battery of claim 1,
wherein the silicon particles satisfy Formula 3 below: ${Dv}_{90} \leq 10 μm$
wherein, in Formula 3, Dv₉₀ is a particle diameter corresponding to 90% of a cumulative volume in a particle size distribution curve of the silicon particles.

4. The negative electrode active material for a lithium secondary battery of claim 1,
wherein the silicon particles satisfy Formula 4 below: $\left[{Dv}_{90}-{Dv}_{10}\right] / {Dv}_{50} \leq 1.1$
wherein, in Formula 4, Dv₅₀ is a particle diameter corresponding to 50% of a cumulative volume in a particle size distribution curve of the silicon particles, Dv₁₀ is a particle diameter corresponding to 10% of the cumulative volume in the particle size distribution curve of the silicon particles, and Dv₉₀ is a particle diameter corresponding to 90% of the cumulative volume in the particle size distribution curve of the silicon particles.

5. The negative electrode active material for a lithium secondary battery of claim 1, wherein a volume average particle diameter (Dv₅₀) of the silicon particles is 4 to 6 µm.

6. The negative electrode active material for a lithium secondary battery of claim 1, wherein a circularity of the silicon particles is 0.86 or more.

7. The negative electrode active material for a lithium secondary battery of claim 1, wherein a tap density of the silicon particles is 0.9 g/cm³ or more.

8. The negative electrode active material for a lithium secondary battery of claim 1, wherein a BET specific surface area of the silicon particles is 1.4 to 2.2 m²/g.

9. The negative electrode active material for a lithium secondary battery of claim 1, wherein an average grain size of the silicon particles is 200 nm or less.

10. The negative electrode active material for a lithium secondary battery of claim 1, wherein a strain of the silicon particles is 10×10⁻⁵ or more.

11. The negative electrode active material for a lithium secondary battery of claim 1, wherein the silicon particles have a single particle form.

12. The negative electrode active material for a lithium secondary battery of claim 1, wherein the silicon particles have a polycrystalline structure.

13. The negative electrode active material for a lithium secondary battery of claim 1, wherein an Si purity of the silicon particles is 98% or more.

14. A negative electrode for a lithium secondary battery, comprising the negative electrode active material of any one of claims 1 to 13.

15. A lithium secondary battery comprising the negative electrode for a lithium secondary battery of claim 14.
